# FASCICULE DE BREVET EUROPEEN

(11) **EP 1 461 142 B1**
(45) Date de publication et mention de la délivrance du brevet: **20.06.2012**
(21) Numéro de dépôt: 03712213.2
(22) Date de dépôt: 07.01.2003
(51) Int. Cl.: B01D 71/02, G03F 7/00, B01D 69/02, B01D 39/16, B01D 67/00

(54) **PROCEDE POUR FABRIQUER UNE FEUILLE PRESENTANT DES PORES TRAVERSANTS ET APPLICATION A LA FABRICATION DE FILTRES MICRONIQUES ET SUBMICRONIQUES**
VERFAHREN ZUM HERSTELLEN EINER FOLIE MIT DURCHGÄNGIGEN POREN UND DEREN ANWENDUNG ZUR HERSTELLUNG VON MIKRON-UND SUBMIKRONFILTERN
METHOD OF PRODUCING A SHEET COMPRISING THROUGH PORES AND THE APPLICATION THEREOF IN THE PRODUCTION OF MICRONIC AND SUBMICRONIC FILTERS

(30) Priorité: 07.01.2002 FR 0200118
(43) Date de publication de la demande: 29.09.2004
(73) Titulaire: CENTRE NATIONAL DE LA RECHERCHE SCIENTIFIQUE (CNRS), 75016 Paris (FR)
(72) Inventeur: LAGARDE, Thierry, 38450 Vif (FR); PELLETIER, Jacques, 3 8400 Saint Martin D'Hères (FR); ARNAL, Yves Alban-Marie, 38320 Poisat (FR)
(74) Mandataire: Bomer, Françoise Marie
(86) Numéro de dépôt international: PCT/FR2003/000020
(87) Numéro de publication internationale: WO 2003/057352

(56) Documents cités:
- EP-A- 0 879 635
- WO-A-01/41905
- US-A- 5 753 014
- US-A- 5 985 164
- PATENT ABSTRACTS OF JAPAN vol. 1998, no. 11, 30 septembre 1998 (1998-09-30) & JP 10 158422 A (TOKAI RUBBER IND LTD), 16 juin 1998 (1998-06-16)
- PATENT ABSTRACTS OF JAPAN vol. 0113, no. 57 (C-458), 20 novembre 1987 (1987-11-20) & JP 62 129106 A (FUJI ELECTRIC CO LTD), 11 juin 1987 (1987-06-11)

## Description

L'invention concerne la fabrication de feuilles et de membranes à pores traversants pour la réalisation de filtres microniques et submicroniques à pores cylindriques calibrés, et les feuilles, membranes et filtres ainsi obtenus :
Les domaines d'application de ces filtres recouvrent des techniques très variées comme la filtration de l'air et plus généralement des gaz, la filtration des effluents liquides et en particulier la filtration tangentielle, la filtration des poudres pour leur séparation ou leur calibration.

Ce type de filtre peut trouver des applications en agro-alimentaire, en pharmacie, dans le domaine du traitement des rejets gazeux ou liquides, dans le domaine de la production et de la fourniture de gaz purs exempts de poussière, et plus généralement dans tous les domaines industriels nécessitant des étapes de séparation et de filtration.

D'autres domaines d'applications comme l'optique VUV, UV, visible, IR et les rayons X peuvent aussi être intéressés par la réalisation de réseaux de pores (ou de trous) dans des matériaux diélectriques, composites (cristaux photoniques) ou métalliques.

On réalise actuellement différents types de filtres par des techniques très diverses.

Pour la filtration tangentielle, les filtres les plus couramment utilisés sont des filtres en alumine ou zircone frittée sur support alumine ou graphite. Ils se présentent généralement sous la forme de tubes aux parois poreuses de diamètre de l'ordre du cm et de 10 à 20 cm de long.

Les filtres réalisés en matériaux frittés, bien qu'utilisés à grande échelle, sont relativement coûteux et présentent un certain nombre d'inconvénients et de limitations. En premier lieu, les pores de matériaux frittés ne sont pas rectilignes et sont au contraire très tortueux et leur section varie le long de leur trajet. Cette géométrie des pores entraîne un colmatage très rapide des pores et rend en outre très difficile sinon impossible le décolmatage des filtres par flux inverse. Ensuite, les matériaux frittés présentent généralement une distribution du diamètre moyen des pores répartivement étendue autour de la valeur moyenne.

L'existence d'une telle distribution exclut donc ce type de filtres pour les applications nécessitant une grande sûreté de séparation. Enfin, la rugosité des surfaces, intrinsèque aux matériaux frittés, n'est pas favorable à un bon écoulement des fluides, en particulier en filtration tangentielle. En outre, il apparaît difficile, voire impossible, de modifier la nature physico-chimique des surfaces dans les méandres des pores.

Une autre technique bien connue est la réalisation de films poreux minces en matériaux polymères de type polysulfones obtenus par une attaque chimique préférentielle le long des trajectoires ioniques obtenues à travers le film en le soumettant dans un accélérateur à un flux d'ions de très haute énergie.

En ce qui concerne la technique utilisant l'attaque chimique préférentielle le long des trajectoires ioniques dans les polysulfones soumis à un bombardement d'ions à haute énergie, les pores ont des trajectoires rectilignes et leur diamètre ne s'écarte que faiblement de leur valeur moyenne (qui dépend de la durée de l'attaque chimique). Cependant, la distribution des pores sur la surface est aléatoire si bien que deux ou plusieurs impacts ioniques voisins peuvent engendrer des pores de diamètres bien supérieurs à celui obtenu à partir d'un impact isolé. Enfin, les films minces de polysulfones sont d'une fragilité extrême, ce qui limite énormément leur champ d'utilisation.

Une autre technique moins connue consiste à réaliser des trous dans une plaque de silicium par gravure plasma du silicium à travers un masque, puis à amincir la plaque jusqu'à ce que les trous débouchent pour former un réseau de pores.

Dans le cas de filtres gravés dans des plaquettes de silicium, les techniques classiques de lithographie et de gravure anisotrope par plasma (cf. par exemple « Anisotropic etching of polymers in S02/02 plasmas » par Michel Pons, Jacques Pelletier, Olivier Joubert (J. Appl. Phys. 75(9) 1 mai 1994)) permettent d'obtenir un réseau de pores calibrés de grande densité aréolaire. Malheureusement, cette technique présente plusieurs inconvénients et limitations, à savoir, i) la nécessité d'amincir la plaquette (typiquement de 500µm à une fraction de µm) afin d'éviter des pertes de charge trop importantes du flux traversant le filtre ; ii) la limitation du procédé aux dimensions maximales des plaquettes existantes ; iii) le coût exorbitant du matériau de départ (monocristal de grande épaisseur, incompatible avec celui des filtres utilisés dans la filtration industrielle ; iv) la fragilité des filtres réalisés à partir d'un matériau cassant (chocs, contraintes) ; v) l'impossibilité de mettre en forme les filtres obtenus (tubes, scellements) ; vi) la résistance inégale à la corrosion (attaque par les solutions fortement basiques et certains acides).

On connaît également, d'après le document WO 01/41905, un procédé de fabrication d'un filtre comprenant une membrane et un support mais dont les pores présentent un facteur de forme n'excédant pas 3 et qui ne peut donc être appliqué à la réalisation de filtres à facteur de forme élevé.

Un but de l'invention est la réalisation de membranes filtrantes minces comportant des réseaux de pores cylindriques calibrés de grande densité aréolaire

Selon la présente invention, on réalise un procédé pour fabriquer une feuille présentant des pores traversants ayant un facteur de forme supérieur à 5, le facteur de forme étant défini comme le rapport de la profondeur des pores à leur diamètre, ce procédé étant caractérisé en ce qu'il comprend les opérations suivantes :
A) préparation d'une feuille, d'une épaisseur de 5µm à quelques dizaines de micromètres, apte à être gravée par une opération lithographique ;
B) réalisation d'un masque sur une face de la feuille puis dépôt sur ce masque d'une couche de résine photosensible ou dépôt sur une face de la feuille d'une couche de résine photosensible faisant à la fois office de résine et de masque ; le masque présentant une sélectivité s de gravure au moins égale à 5, la sélectivité S étant définie comme le rapport de la vitesse de gravure VF du matériau de la feuille à la vitesse de gravure VM du masque,
C) réalisation de pores traversants dans la couche de résine par photolithographie, selon la configuration de pores à réaliser et éventuellement gravure traversante du masque à travers les pores de la couche de résine, si le masque est distinct de la résine,
D) gravure anisotrope traversante de la feuille, à partir des pores du masque, pour réaliser dans la feuille des pores ayant un facteur de forme supérieur à 5.

Dans des modes de réalisation préférés, le procédé comprend encore une ou plusieurs des opérations suivantes :
- le procédé comprend un découpage de la feuille en membranes individuelles ;
- on utilise une feuille sen matériau métallique ;
- la réalisation de pores dans la couche de résine est obtenue par transfert par interférences d'une image de la configuration de pores ;
- la résine photosensible constitue régalement le masque ;
- l'une au moins des opérations de gravure est réalisée dans un plasma.

Si la rugosité de la feuille est trop importante pour l'opération lithographique, sa surface doit subir des traitements préalables de polissage chimique ou électrochimique.

Pour la réalisation d'un filtre, la feuille ou la membrane découpée dans la feuille est utilisée à plat ou roulée en tube, et fixée à un support, de façon en soi connue.

Certaines des opérations peuvent être réunies en une seule étape ou peuvent comporter plusieurs étapes, par exemple la réalisation de couches successives.

La feuille de départ, de préférence en matière métallique, peut se présenter sous forme d'une feuille de grandes dimensions ou d'un rouleau. En variante, la feuille est en matériau polymère ou composite, ou est recouverte d'un film métallique.

Le masque est réalisé par tout moyen en soi connu.

Le carbone peut avantageusement être utilisé comme masque de pulvérisation car il présente généralement un rendement de pulvérisation bien plus faible que celui des métaux.

La réalisation de l'image est obtenue par dépôt d'une couche de résine (photosensible, électrosensible, sensible aux rayons X, etc) et insolation de la résine par un flux d'énergie (UV, photons, électrons, rayons X, etc). la résine peut éventuellement faire à la fois office de résine et de masque (cas des résines silylées en plasma d'oxygène).

Pour la réalisation des gravures profondes à facteur de forme très élevé dans un plasma, il est possible d'utiliser :
1) soit des gaz de gravure capables de former, par des réactions chimiques induites par le bombardement ionique , des produits de réaction volatils avec le métal ou les éléments constituant la feuille métallique ou le film. Une condition nécessaire est l'existence de composés volatils stables avec les éléments constituants le film ;
2) soit des gaz peu ou pas réactifs (gaz rares purs ou en mélange) permettant de pulvériser le film par bombardement ionique à forte énergie.

Dans le premier cas, pour obtenir une gravure plasma parfaitement anisotrope on peut mettre en oeuvre :
a) la gravure cryogénique qui permet de ralentir les cinétiques de gravure chimique spontanée jusqu'à les rendre quasiment nulles ;
b) la gravure avec passivation latérale des parois à l'aide d'un dépôt protecteur dont la cinétique de gravure chimique spontanée est inférieure à la vitesse de croissance du dépôt protecteur ;
c) la gravure avec blocage des cinétiques de réaction spontanée par absorption concurrentielle sur les parois d'un élément réactif inhibant les réactions spontanées ;
d) la gravure avec blocage des cinétiques de réaction spontanée par les effets stériques (cas de la gravure avec les halogènes dont le rayon des atomes varie de façon significative).

Le masque est enlevé après l'opération de gravure, si nécessaire.

Les membranes sont de préférence réalisées dans des feuilles ou dans des films continus (polymères, feuillards métalliques) dont la largeur est de l'ordre du mètre et qui fourniront chacune plusieurs membranes. La fabrication est de préférence réalisée à plat, en ligne, par défilement séquentiel de la feuille, par analogie aux procédés de fabrication collectifs utilisés en microélectronique. A chaque séquence, la feuille avance d'un cran, d'un poste au poste suivant, chaque poste correspondant à une opération ou à une sous-opération du procédé de fabrication.

Pour la réalisation d'un filtre tubulaire, la membrane perforée est roulée en cylindre puis soudée bord à bord. De préférence, les zones destinées à la soudure sont exemptes de pores, ce qui nécessite leur protection pendant l'opération de lithographie ou de gravure.

Pour la réalisation d'un filtre plan, la membrane est éventuellement scellée sur un support.

Outre un coût de fabrication très faible résultant d'un procédé de fabrication en ligne permettant des cadences élevées, la réalisation de filtres réalisés selon l'invention à partir de membranes minces présentent de nombreux avantages, à savoir :
a) nombre d'étapes de fabrication réduit (par exemple, pas d'amincissement nécessaire)
b) possibilité de réaliser des filtres de toutes formes et de toutes dimensions,
c) bonne tenue mécanique des filtres métalliques, principalement,
d) bonne résistance à la température pour les filtres réalisés dans des films en métal réfractaire,
e) bonne résistance à la corrosion en fonction de la composition du filtre,
f) grande sûreté de séparation due à la parfaite calibration des pores,
g) la surface des filtres présente une faible rugosité,
h) le fait que les filtres présentent des pores cylindriques traversants permet un décolmatage très efficace par flux inverse,
i) l'absence de méandres le long des pores permet d'envisager un traitement efficace de leur surface par un procédé physico-chimique,
j) la grande densité aréolaire de pores permet de filtrer des flux importants de matière (liquides, gaz, poudres).

L'invention permet de réaliser des filtres à grande densité aréolaire de pores microniques et submicroniques calibrés.

Les dimensions des tubes peuvent être identiques à celles des tubes actuels. L'épaisseur des parois peut varier de 5 µm à quelques dizaines de micromètres en fonction du diamètre des pores. En effet, si le diamètre des pores est faible, il est préférable de réduire corrélativement la longueur des pores (et donc l'épaisseur de la membrane) si l'on ne veut pas réduire de façon trop importante la conductance des pores. Toutefois, la réduction de l'épaisseur du film accroît aussi sa fragilité ce qui peut nécessiter l'utilisation de supports ou de renforts mécaniques (grilles, etc).

Pour les applications à la microfiltration, il faut pouvoir disposer d'une gamme étendue de diamètres de pores, depuis le dixième de micromètre ou moins jusqu'à quelques dizaines de micromètres. Si le diamètre des pores est égal à la distance entre pores, la densité de pores est fixée par le diamètre des pores : 10⁸ pores/cm² pour un diamètre de pores de 0,5µm, 10⁶ pores/cm² pour un diamètre de pores de 5µm, 10⁴ pores/cm² pour un diamètre de pores de 50µm, etc.

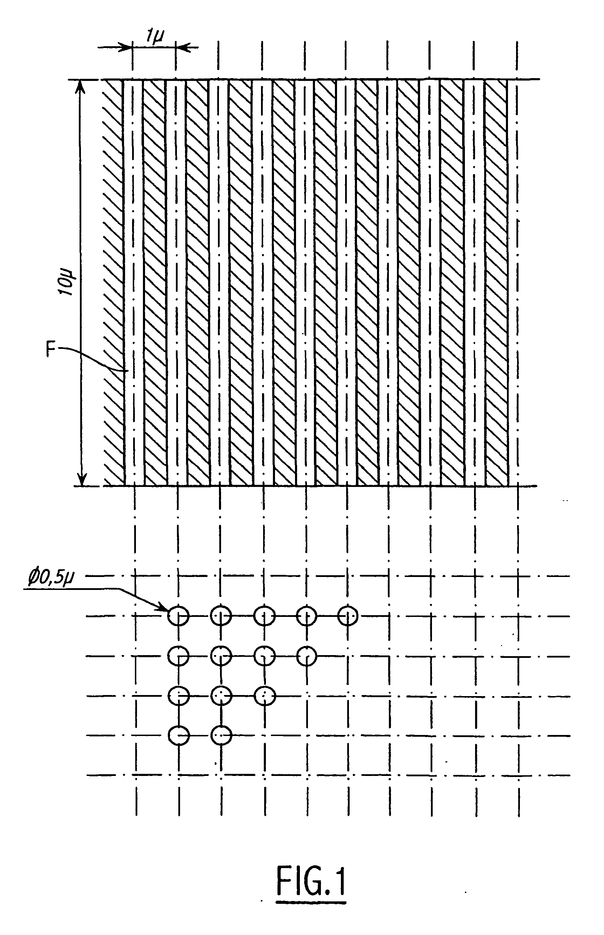

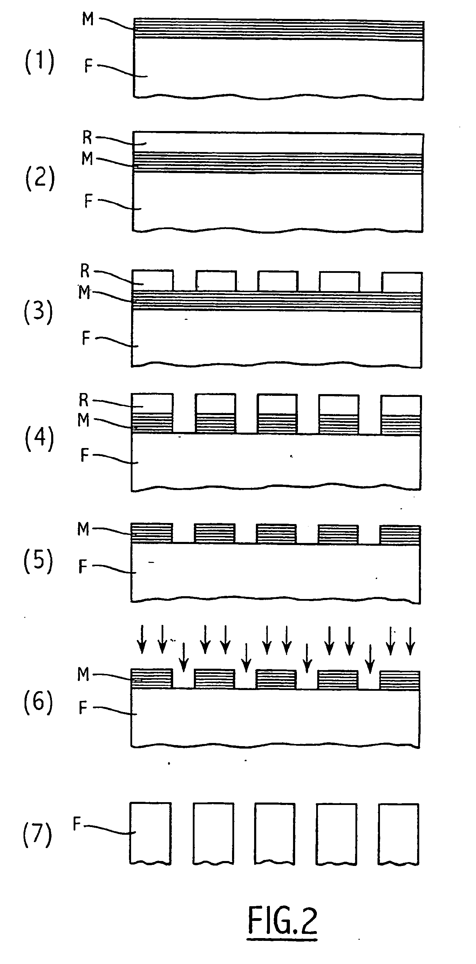

On a représenté sur le dessin joint :
- en fig. 1, un schéma en coupe verticale et en vue de dessus d'une feuille comportant un réseau de pores, réalisée selon l'invention ;
- en fig. 2, un schéma des étapes successives d'un exemple de mise en oeuvre du procédé de fabrication de l'invention.

Sur la figure 1, la partie supérieure de la figure est une coupe verticale d'une partie d'une feuille comportant un réseau de pores et la partie inférieure de la figure est une vue de dessus partielle de la feuille.

A titre d'exemple, la feuille est une feuille métallique par exemple une feuille de molybdène de 10 micromètres d'épaisseur, les pores forment un réseau carré, ont un diamètre de 0,5 micromètre, une profondeur de 10 micromètres (soit un facteur de forme de 20) et sont espacés de 0,5 micromètres, soit une densité aréolaire de 10⁸ pores/cm².

On a fabriqué le réseau en réalisant les étapes suivantes (figure 2) :
(1) dépôt sur la feuille F d'un masque M constitué par une couche d'aluminium de 1 micromètre d'épaisseur ;
(2) dépôt sur le masque d'une couche R d'une résine photosensible d'une épaisseur de 1,2 micromètres ;
(3) transfert par interférences de l'image du réseau de pores dans la résine R et développement de la résine par une technique de la microélectronique ;
(4) gravure du masque au travers des pores de la couche de résine par un gaz contenant du chlore, du brome ou de l'iode ;
(5) enlèvement de la résine résiduelle (facultatif) ;
(6) gravure anisotrope du film F par un gaz à base de fluor au travers des pores du masque ;
(7) enlèvement du masque (facultatif).

Chaque opération est réalisée alors que la feuille est arrêtée à un poste d'une suite de postes à travers lesquels la feuille est déplacée par à-coups.

Eventuellement, plusieurs opérations sont réalisées successivement en un même poste.

La feuille est ensuite découpée en fonction des dimensions des filtres pour fournir une ou plusieurs membranes, et les membranes sont fixées à des supports permettant l'utilisation des membranes comme filtres.

L'invention n'est pas limitée à cet exemple de réalisation, donné uniquement à titre illustratif.

## Revendications

1. Procédé pour fabriquer une feuille présentant des pores traversants ayant un facteur de forme supérieur à 5, le facteur de forme étant défini comme le rapport de la profondeur des pores à leur diamètre, ce procédé étant **caractérisé en ce qu'**il comprend les opérations suivantes :
A) préparation d'une feuille, d'une épaisseur de 5µm à quelques dizaines de micromètres, apte à être gravée par une opération lithographique ;
B) réalisation d'un masque sur une face de la feuille puis dépôt sur ce masque d'une couche de résine photosensible ou dépôt sur une face de la feuille d'une couche de résine photosensible faisant à la fois office de résine et de masque ; le masque présentant une sélectivité S de gravure au moins égale à 5, la sélectivité S étant définie comme le rapport de la vitesse de gravure VF du matériau de la feuille à la vitesse de gravure VM du masque,
C) réalisation de pores traversants dans la couche de résine, par photolithographie, selon la configuration de pores à réaliser et éventuellement gravure traversante du masque à travers les pores de la couche de résine, si le masque est distinct de la résine,
D) gravure anisotrope traversante de la feuille, à partir des pores du masque, pour réaliser dans la feuille des pores ayant un facteur de forme supérieur à 5.

2. Procédé selon la revendication 1 et qui comprend un découpage de la feuille en membranes individuelles.

3. Procédé selon la revendication 1 ou 2, dans lequel on utilise une feuille en matériau métallique.

4. Procédé selon l'une des revendications 1 à 3 dans lequel la réalisation des pores dans la couche de résine est obtenue par transfert par interférences d'une image de la configuration de pores.

5. Procédé selon l'une des revendications 1 à 4, dans lequel l'une au moins des opérations de gravure est réalisée dans un plasma.

6. Procédé selon l'une des revendications 1 à 5, dans lequel les opérations sont réalisées successivement au cours d'un défilement séquentiel de la feuille.

7. Procédé selon l'une des revendications 1 à 6 qui comprend une opération de roulage en cylindre de la feuille ou d'une membrane découpée dans la feuille et soudage de ses bords.

## Claims

1. A method of fabricating a sheet presenting through pores having an aspect ratio greater than 5, where aspect ratio is defined as the ratio of the depth of the pores to their diameter, this method being **characterized in that** it comprises the following operations:
A) preparing a sheet having thickness of 5 µm to a few tens of micrometers, suitable for being etched by a lithographic operation;
B) making a mask on a face of the sheet, then depositing a layer of photosensitive resin on this mask or depositing a layer of photosensitive resin acting simultaneously as a resin and as a mask, on a face of the sheet, the mask presenting etching selectivity S of at least 5, where etching selectivity S is defined as the ratio of the speed VF at which the material of the sheet is etched to the speed VM at which the material of the mask is etched;
C) making through holes in the layer of resin by photolithography, matching the configuration of pores to be made; and possibly etching through the mask via the pores in the layer of resin, if the mask is distinct of the resin;
D) anisotropically etching through the sheet from the pores in the mask in order to make pores in the sheet having an aspect ratio greater than 5.

2. A method according to claim 1, and which includes cutting the sheet up into individual membranes.

3. A method according to claim 1 or claim 2, in which a sheet made of metal is used.

4. A method according to any one of claims 1 to 3, in which pores are made in the layer of resin by transferring an image of the configuration of the pores by interference.

5. A method according to any one of claims 1 to 4, in which at least one of the etching operations is performed in a plasma.

6. A method according to any one of claims 1 to 5, in which the operations are performed in succession during sequential travel of the sheet.

7. A method according to any one of claims 1 to 6, which includes an operation of rolling the sheet or a membrane cut out from the sheet into a cylinder and bonding together its edges.

## Patentansprüche

1. Verfahren zur Herstellung einer Folie mit durchgängigen Poren eines Formfaktors von größer als 5, wobei der Formfaktor definiert ist als das Verhältnis der Porentiefe zum Porendurchmesser, wobei das Verfahren **dadurch gekennzeichnet ist, dass** es die folgenden Schritte aufweist:
A) Vorbereitung einer lithographisch ätzbaren Folie mit einer Dicke von 5 µm bis einigen zehn Mikrometern;
B) Bildung einer Maske an einer Fläche der Folie, dann Aufbringen einer fotosensitiven Harzschicht auf diese Maske oder Aufbringen einer fotosensitiven Harzschicht, die als Harz und zugleich als Maske dient, auf eine Fläche der Folie; wobei die Maske eine Ätzselektivität S von mindestens 5 hat und die Selektivität S definiert ist als das Verhältnis der Ätzgeschwindigkeit VF des Materials der Folie zur Ätzgeschwindigkeit VM der Maske;
C) Bildung von durchgängigen Poren in der Harzschicht mittels Fotolithographie entsprechend der zu realisierenden Porenkonfiguration und gegebenenfalls durchgängige Ätzung der Maske durch die Poren der Harzschicht hindurch, wenn Maske und Harzschicht nicht identisch sind;
D) anisotrope durchgängige Ätzung der Folie ausgehend von den Poren der Maske, um in der Folie Poren zu bilden, deren Formfaktor größer als 5 ist.

2. Verfahren nach Anspruch 1, außerdem mit Schneiden der Folie in einzelne Membranen.

3. Verfahren nach Anspruch 1 oder 2, in welchem eine Folie aus einem metallischen Material verwendet wird.

4. Verfahren nach einem der Ansprüche 1 bis 3, in welchem die Bildung der Poren in der Harzschicht erzielt wird durch Übertragung eines Bildes der Porenkonfiguration mittels Interferenzen.

5. Verfahren nach einem der Ansprüche 1 bis 4, in welchem mindestens einer der Ätzschritte in einem Plasma erfolgt.

6. Verfahren nach einem der Ansprüche 1 bis 5, in welchem die Schritte der Reihe nach durchgeführt werden, während die Folie fortlaufend vorangerückt wird.

7. Verfahren nach einem der Ansprüche 1 bis 6 mit einem Schritt zum Aufrollen der Folie oder einer aus der Folie ausgeschnittenen Membran zu einem Zylinder und zum Verschweißen der Ränder aufweist.
